(19) Europäisches Patentamt
European Patent Office
Office européen des brevets

(11) **EP 4 356 185 B1**

(12) **EUROPÄISCHE PATENTSCHRIFT**

(45) Veröffentlichungstag und Bekanntmachung des Hinweises auf die Patenterteilung:
**28.01.2026   Patentblatt 2026/05**

(21) Anmeldenummer: **22840724.3**

(22) Anmeldetag: **20.12.2022**

(51) Internationale Patentklassifikation (IPC):
**G02C 7/02** (2006.01)    **G02C 13/00** (2006.01)
**G01N 19/02** (2006.01)    **G02B 1/10** (2015.01)
**C09D 127/12** (2006.01)    **C09D 171/00** (2006.01)

(52) Gemeinsame Patentklassifikation (CPC):
**G01N 19/02; G02B 1/18**

(86) Internationale Anmeldenummer:
**PCT/EP2022/087033**

(87) Internationale Veröffentlichungsnummer:
**WO 2023/118169 (29.06.2023 Gazette 2023/26)**

(54) **BRILLENGLAS MIT VERMINDERTEN REIBUNGSEIGENSCHAFTEN, MESSVERFAHREN ZUR BESTIMMUNG DER GLATTHEIT DES BRILLENGLASES SOWIE VERFAHREN ZUR HERSTELLUNG DES BRILLENGLASES**

SPECTACLE LENS HAVING REDUCED FRICTION PROPERTIES, MEASUREMENT METHOD FOR DETERMINING THE SMOOTHNESS OF THE SPECTACLE LENS, AND METHOD FOR PRODUCING THE SPECTACLE LENS

VERRE DE LUNETTES AYANT DES PROPRIÉTÉS DE FROTTEMENT RÉDUITES, PROCÉDÉ DE MESURE POUR DÉTERMINER LA PLANÉITÉ DU VERRE DE LUNETTES ET PROCÉDÉ DE FABRICATION DU VERRE DE LUNETTES

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **21.12.2021   DE 102021134053**

(43) Veröffentlichungstag der Anmeldung:
**24.04.2024   Patentblatt 2024/17**

(60) Teilanmeldung:
**25201075.6 / 4 678 705**

(73) Patentinhaber: **Rodenstock GmbH**
**80687 München (DE)**

(72) Erfinder:
• **BRUNNER, Hermann**
  **82234 Wessling (DE)**
• **GRAGE, Yvonne**
  **81547 München (DE)**

• **URBAN, Arne**
  **81827 München (DE)**
• **VÖGT, Michael**
  **82205 Gilching (DE)**
• **GRAU, Markus**
  **85737 Ismaning (DE)**
• **MERKELBACH, Philipp**
  **82347 Bernried (DE)**
• **KEIL, Andreas**
  **84453 Mühldorf am Inn (DE)**

(74) Vertreter: **Müller-Boré & Partner**
**Patentanwälte PartG mbB**
**Friedenheimer Brücke 21**
**80639 München (DE)**

(56) Entgegenhaltungen:
**EP-A1- 2 078 765       JP-B2- 5 156 251**
**US-A1- 2005 179 862   US-A1- 2014 211 150**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die vorliegende Erfindung betrifft ein Messverfahren zur Bestimmung der Glattheit eines Brillenglases.

Im Stand der Technik sind Brillengläser, welche mit einer Mehrzahl von verschiedenen Schichten vergütet sein können, bekannt. So lässt sich durch Vergüten mit einer Hartschicht das Brillenglas vor Kratzern schützen. Eine Reflexminderung lässt sich durch Vergüten mit einer Interferenz-/Entspiegelungsschicht erreichen. Das Vergüten mit einer funktionellen Beschichtung, welche mitunter auch als Topcoat oder Cleancoat bezeichnet wird, dient schließlich der Abweisung von Schmutz und Wassertropfen. Ausgehend von der Oberfläche des Brillenglases weist ein typischer Schichtaufbau die Schichtfolge Hartschicht, Interferenz-/Entspiegelungsschicht und funktionelle Beschichtung auf. Letztere stellt somit die äußerste Vergütungsschicht dar. Jede der vorstehend genannten Vergütungsschichten kann dabei aus einer einzigen Schicht oder aus einem Schichtsystem mit mehreren Schichten bestehen.

Um gegenüber Schmutz und Wassertropfen abweisend zu sein, besitzt die funktionelle Beschichtung in der Regel sowohl oleophobe als auch hydrophobe Eigenschaften. Ein Maß hierfür ist der jeweilige Kontaktwinkel, den eine entsprechende Flüssigkeit auf der Oberfläche des Brillenglases ausbildet. Hierbei gilt im Allgemeinen, dass die oleophoben und hydrophoben Eigenschaften umso ausgeprägter sind, je größer der Kontaktwinkel der jeweiligen Flüssigkeit auf der Oberfläche des Brillenglases ist. Zwar lassen sich mit einer funktionellen Beschichtung vergütete Brillengläser gut von Schmutz und Wassertropfen, welche ansonsten an die Oberfläche des Brillenglases haften würden, befreien. Dennoch muss das Brillenglas von Zeit zu Zeit gereinigt werden, etwa durch Putzen mit einem Wischgegenstand, wie beispielsweise einem Mikrofasertuch oder dergleichen. Wird das Brillenglas zuvor mit fließendem Wasser in Kontakt gebracht, bedarf es ebenfalls eines derartigen Wischgegenstandes, um das Brillenglas zu trocknen. Vorliegend wird unter einem Putzen auch ein solches Trocknen verstanden.

Grundsätzlich erfordert das Gleiten mit dem Wischgegenstand über die Oberfläche des Brillenglases einen gewissen Kraftaufwand, welcher sich zudem erhöht, wenn die Wischgeschwindigkeit zunimmt. Ist die beim Wischen aufgebrachte Kraft zu gering, bleibt der Wischgegenstand auf dem Brillenglas haften. Hierdurch kann es zu einem Rutschen der Finger über den Wischgegenstand kommen. Dies wiederum beeinträchtigt den Putzvorgang. Im Ergebnis fühlt sich die Oberfläche des Brillenglases beim Putzen mit dem Wischgegenstand nicht ausreichend glatt an.

Unter idealen Bedingungen erreicht man ein optimales Putzergebnis durch einmaliges Wischen mit einem sauberen Mikrofasertuch über die Oberfläche des Brillenglases, was auch als sogenannter "one wipe clean" bezeichnet wird. Dennoch machen die meisten Brillenträger beim Putzen des Brillenglases mehrere alternierende Putzhübe in der Breitenrichtung des Brillenglases, d.h. alternierend von links nach rechts bzw. rechts nach links. In diesem Fall wird ein Brillenglas, dessen Oberfläche sich nicht ausreichend glatt anfühlt, als besonders störend wahrgenommen.

Die im Stand der Technik bekannten Ansätze zur Vergütung eines Brillenglases mit einer funktionellen Beschichtung zielen typischerweise auf die Verbesserung der oleophoben und hydrophoben Eigenschaften ab, um so die Oberfläche des Brillenglases noch abweisender gegenüber Anhaftungen wie Schmutz und Wassertropfen zu machen. Demnach lag bei der Vergütung von Brillengläsern bislang der Fokus auf einer Verbesserung der schmutz- und wasserabweisenden Eigenschaften des Brillenglases und nicht etwa auf einem besonders leichtgängigen Wischen mit geringem Kraftaufwand.

In diesem Zusammenhang offenbart EP 2 078 765 A1 ein Dampfabscheidungsmaterial, ein Verfahren zur Herstellung eines optischen Elements oder einer Kunststofflinse für eine Brille unter Verwendung davon sowie eine Kunststofflinse für eine Brille.

Weiterhin ist aus US 2005/179862 A1 eine weiche Kontaktlinse mit hervorragendem Tragekomfort auf den Augen bekannt.

Der vorliegenden Erfindung liegt somit die Aufgabe zugrunde, ein Messverfahren zur Bestimmung der Glattheit eines Brillenglases bereitzustellen. Das Brillenglas, dessen Glattheit bestimmt werden soll, kann mit einer funktionellen Beschichtung vergütet sein, so dass neben der Abweisung von Schmutz und Wassertropfen ein besonders leichtgängiges Wischen mit geringem Kraftaufwand möglich ist.

Die vorstehende Aufgabe wird durch ein Messverfahren mit den Merkmalen des Anspruchs 1 gelöst. Bevorzugte Ausführungsformen sind in den Unteransprüchen offenbart.

So betrifft die vorliegende Erfindung ein Messverfahren zur Bestimmung der Glattheit eines Brillenglases mit Hilfe eines Rheometers unter Bestimmung dynamischer Reibungskoeffizienten gegenüber einem Mikrofasertuch, welches eine Kreisbahn um die Mitte des Brillenglases beschreibt, wobei die Bestimmung dynamischer Reibungskoeffizienten bei Geschwindigkeiten im Bereich von 0,005 m/s bis 0,4 m/s tangential zur beschriebenen Kreisbahn sowie tangential zur Oberfläche des Brillenglases erfolgt,

dadurch gekennzeichnet, dass die Glattheit des Brillenglases durch einen haptischen Glattheitskoeffizienten HGK ausgedrückt wird und das Verfahren umfasst:

Wischen mit einem Mikrofasertuch in einer rotierenden Bewegung um die Mitte des Brillenglases, wobei das Wischen mit Hilfe eines Rotors, der auf die konvexe Seite des Brillenglases abgesenkt wird, erfolgt, der Andruck des Mikrofasertuchs auf die zu messende Oberfläche des Brillenglases durch einen elastischen Stempel mit ringförmiger Auflagefläche geschieht, und sich das Mikrofasertuch im Bereich der ringförmigen Auflagefläche relativ zur Oberfläche des Brillenglases mit einer Geschwindigkeit im Bereich von 0,005 m/s bis 0,4 m/s tangential zum Außenradius der ringförmigen Auflagefläche bewegt,

Ermitteln des Drehmoments während der rotierenden Bewegung des Mikrofasertuchs mit Hilfe eines Rheometers,

Bestimmen des dynamischen Reibungskoeffizienten anhand des zuvor ermittelten Drehmoments,

Wiederholen der vorstehenden Schritte bei einer anderen Geschwindigkeit im Bereich von 0,005 m/s bis 0,4 m/s tangential zum Außenradius der ringförmigen Auflagefläche, und

Berechnen des haptischen Glattheitskoeffizienten HGK aus mindestens zwei mit verschiedenen tangentialen Geschwindigkeiten bestimmten dynamischen Reibungskoeffizienten.

Brillengläser, welche aufgrund ihrer funktionellen Beschichtung einen haptischen Glattheitskoeffizienten HGK von höchstens 0,28, bevorzugt von höchstens 0,25, und/oder einen haptischen Glattheitskoeffizienten R_HGK von höchstens 0,85, bevorzugt von höchstens 0,80 aufweisen, wie im Detail weiter unten beschrieben, erlauben ein besonders leichtgängiges Wischen mit geringem Kraftaufwand. Zudem ist der Kraftaufwand bei zunehmender Wischgeschwindigkeit nur geringfügig erhöht. So fühlt sich die Oberfläche eines derartigen Brillenglases beim Wischen besonders glatt an, was haptisch wiederum als sehr angenehm empfunden wird.

Der dynamische Reibungskoeffizient kann als ein Maß für die gefühlte Glattheit, mit der die Oberfläche des Brillenglases wahrgenommen wird, aufgefasst werden. Der dynamische Reibungskoeffizient bezieht sich hierbei auf die Reibungskraft, welche zu überwinden ist, um eine Bewegung des Wischgegenstandes auf der Oberfläche des Brillenglases, wie etwa beim Putzen des Brillenglases mit einem Mikrofasertuch oder dergleichen, auszuführen.

Grundsätzlich ist der dynamische Reibungskoeffizient abhängig von der Geschwindigkeit der Wischbewegung. Gelegentlich wird er daher auch als geschwindigkeitsabhängiger dynamischer Reibungskoeffizient bezeichnet. Im Grunde genommen bedeutet dies, dass der dynamische Reibungskoeffizient kontinuierlich bis zur maximalen Geschwindigkeit der Wischbewegung bestimmt werden müsste, um die gefühlte Glattheit messtechnisch exakt abzubilden. Wie von Seiten der Erfinder herausgefunden wurde, lässt sich die messtechnische Abbildung der gefühlten Glattheit jedoch stark vereinfachen, wie nachstehend im Zusammenhang mit dem erfindungsgemäßen Messverfahren erläutert.

Im Rahmen der vorliegenden Erfindung beschreibt die Bewegung zur messtechnischen Bestimmung des dynamischen Reibungskoeffizienten eine Kreisbahn um die Mitte des Brillenglases. Die Geschwindigkeit, auf die sich der dynamische Reibungskoeffizient bezieht, ist tangential zur beschriebenen Kreisbahn sowie tangential zur Oberfläche des Brillenglases. Sie wird daher gelegentlich auch als tangentiale Geschwindigkeit bezeichnet. Als praxisrelevant für die Geschwindigkeit ist hierbei ein Bereich von 0,005 m/s bis 0,4 m/s anzusehen, da das Putzen eines Brillenglases typischerweise mit einer Geschwindigkeit in eben diesem Geschwindigkeitsbereich erfolgt. Wie durch Messungen festgestellt werden konnte, liegt die maximale Geschwindigkeit der Wischbewegung typischerweise bei einem Wert von 0,2 m/s.

Bei der Bestimmung des dynamischen Reibungskoeffizienten wird vorliegend ein Mikrofasertuch des Typs "Savina MX", hergestellt von "kbSeiren", Osaka, Japan, mit den nachstehenden Eigenschaften verwendet:

| | |
|---|---|
| • Faserart: | ultrafeine Mikrofaser "BelimaX" |
| • Zusammensetzung: | 70% Polyester, 30% Nylon |
| • Dicke: | 0,32 mm |
| • flächenbezogene Masse: | 165 g/m$^2$ |
| • längenbezogene Anzahl der Längsfäden: | 78/2,54 cm |
| • längenbezogene Anzahl der Kettfäden: | 81/2,54 cm |

Hierbei wird mit dem Mikrofasertuch in einer rotierenden Bewegung um die Mitte des Brillenglases mit der darauf aufgebrachten funktionellen Beschichtung gewischt. Beim Wischen mit dem Mikrofasertuch muss sichergestellt sein, dass vorab keinerlei reibende Aktion auf der Oberfläche des Brillenglases ausgeführt wurde, welche deren Eigenschaften verändern könnte. Der Andruck des Mikrofasertuchs auf die zu messende Oberfläche des Brillenglases geschieht durch einen elastischen Stempel mit ringförmiger Auflagefläche und beträgt etwa 8380 N/m$^2$. Bei einem Innenradius von 17,5 mm und einem Außenradius von 20,5 mm der ringförmigen Auflagefläche entspricht dies einer Andruckkraft von 3 N. Im Querschnitt betrachtet weist der elastische Stempel eine rechteckige Form mit einer Höhe von 3 mm auf. Der elastische Stempel ist aus Silikon gefertigt und besitzt eine Shore-Härte A von 40.

Im Bereich der ringförmigen Auflagefläche des elastischen Stempels bewegt sich das Mikrofasertuch relativ zur Oberfläche des Brillenglases. Um der Geschwindigkeitsabhängigkeit des dynamischen Reibungskoeffizienten Rechnung zu tragen, wird der dynamische Reibungskoeffizient zweckmäßigerweise in dem vorstehend genannten Geschwindigkeitsbereich von 0,005 m/s bis 0,4 m/s bestimmt, wobei mit der Geschwindigkeit, wie vorstehend erwähnt, die tangentiale Geschwindigkeit gemeint ist. Ausgehend von einem Anfangswert wird die Geschwindigkeit stufenweise erhöht.

Während der rotierenden Bewegung des Mikrofasertuchs wird mit Hilfe eines Rheometers das Drehmoment ermittelt. Dieses ist über den effektiven Radius der ringförmigen Auflagefläche des elastischen Stempels mit der Reibungskraft, welche das Mikrofasertuch für eine gleichförmige Bewegung relativ zur Oberfläche des Brillenglases überwinden muss, wie folgt verknüpft:

$$\text{Drehmoment} = \text{Reibungskraft} \times \text{effektiver Radius} \quad (I)$$

Der effektive Radius lässt sich mit dem mittleren Radius annähern. Dieser entspricht dem gemittelten Radius der ringförmigen Auflagefläche des elastischen Stempels und lässt sich wie folgt berechnen:

$$\text{mittlerer Radius} = \frac{\text{Außenradius} + \text{Innenradius}}{2} \quad (II)$$

Der dynamische Reibungskoeffizient, abgekürzt als $\mu_d$, ist mit dem Drehmoment über den effektiven Radius und die Andruckkraft wiederum wie folgt verknüpft:

$$\mu_d = \frac{\text{Drehmoment}}{\text{effektiver Radius} \times \text{Andruckkraft}} = \frac{\text{Reibungskraft}}{\text{Andruckkraft}} \quad (III)$$

Für jede Geschwindigkeit v ergibt sich ein individuelles Drehmoment(v), bedingt durch eine individuelle Reibungskraft(v), und damit auch ein individueller dynamischer Reibungskoeffizient(v), abgekürzt als $\mu_d(v)$:

$$\mu_d(v) = \frac{\text{Drehmoment}(v)}{\text{effektiver Radius} \times \text{Andruckkraft}} = \frac{\text{Reibungskraft}(v)}{\text{Andruckkraft}} \quad (IV)$$

Um die gefühlte Glattheit messtechnisch abzubilden, ist es entscheidend, wie bei einem Putzhub die Geschwindigkeit v auf den Weg s über die Oberfläche des Brillenglases während der Zeit t verteilt ist. Untersuchungen unter Verwendung einer Kamera mit hoher Bildfrequenz zeigen, dass sich bei einem Putzhub die Geschwindigkeitsverteilung entlang des Wegs, den der Wischgegenstand hierbei zurücklegt, sehr gut mit einer harmonischen Schwingung annähern lässt, wobei der Wischgegenstand an den Umkehrpunkten zum Stillstand kommt. Aufgrund der Symmetrie der Wischbewegung als harmonische Schwingung ist es ausreichend, dass die Geschwindigkeitsverteilung lediglich für einen 1/4-Putzhub betrachtet wird, d.h. von der Mitte des Brillenglases mit der Position s = 0 beim Zeitpunkt t = 0, wo die Wischbewegung ihre Maximalgeschwindigkeit $v_{max}$ erreicht, zum Umkehrpunkt mit der Position s = $s_{max}$ beim Zeitpunkt t = T/4, wo die Wischbewegung zum Stillstand kommt. T bezeichnet hierbei die Dauer eines gesamten Putzhubs, entsprechend einer vollständigen Schwingungsperiode. Für den Weg eines 1/4-Putzhubs als Funktion der Zeit ergibt sich folgender Zusammenhang:

$$s(t) = s_{max} \times \sin(2\pi/T \times t) = s_{max} \times \sin(\omega \times t) \ \text{mit } t \in [0; T/4] \quad (V)$$

Aufgelöst nach der Zeit ergibt sich folgender Ausdruck:

$$t(s) = 1/\omega \times \arcsin(s/s_{max}) \ \text{mit } s \in [0; s_{max}] \quad (VI)$$

Leitet man den Weg nach der Zeit ab, erhält man die Geschwindigkeit als Funktion der Zeit:

$$v(t) = ds(t)/dt = s_{max} \times \cos(\omega \times t) \times \omega = v_{max} \times \cos(\omega \times t) \quad (VII)$$

Durch Ersetzen der Zeit mit dem vorstehenden Ausdruck erhält man schließlich die Geschwindigkeit als Funktion des Wegs:

$$v(s) \ = \ v_{max} \times \cos(\arcsin(s/s_{max})) \ = \ v_{max} \times \sqrt{1 - (s/s_{max})^2} \quad \text{(VIII)}$$

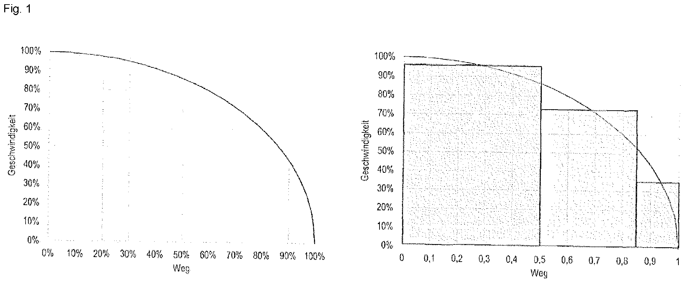

Die Geschwindigkeit als Funktion des Wegs ist in Fig. 1 für einen 1/4-Putzhub veranschaulicht. Die Kurve, welche die Geschwindigkeit beschreibt, lässt sich in drei Abschnitte unterteilen. Diese lassen sich wiederum als Balken darstellen, deren Fläche jeweils der Fläche unter dem dazugehörigen Kurvenabschnitt entspricht. Wie sich aus der Darstellung entnehmen lässt, werden 50% des Wegs mit einer mittleren Geschwindigkeit von 95% der maximalen Geschwindigkeit zurückgelegt. Weitere 35% des Wegs werden mit einer mittleren Geschwindigkeit von 72% der maximalen Geschwindigkeit zurückgelegt. Die restlichen 15% des Wegs werden mit einer mittleren Geschwindigkeit von 35% der maximalen Geschwindigkeit zurückgelegt. Basierend auf der Gewichtung der drei Geschwindigkeiten entlang des Wegs (50% des Wegs mit 95% $v_{max}$, 35% des Wegs mit 72% $v_{max}$ und 15% des Wegs mit 35% $v_{max}$) lässt sich ein entsprechend gewichteter mittlerer dynamischer Reibungskoeffizient angeben. Der gewichtete mittlere dynamische Reibungskoeffizient, abgekürzt als $\overline{\mu_d}$, welcher ein Maß für die gefühlte Glattheit ist, ergibt sich dabei wie folgt:

$$\overline{\mu_d} \ = \ 0{,}50 \times \mu_d(95\% \ v_{max}) + 0{,}35 \times \mu_d(72\% \ v_{max}) + 0{,}15 \times \mu_d(35\% \ v_{max}) \quad \text{(IX)}$$

Setzt man für $v_{max}$ einen Wert von 0,2 m/s ein, wie er für die maximale Geschwindigkeit der Wischbewegung typisch ist, erhält man für den gewichteten mittleren dynamischen Reibungskoeffizienten:

$$\overline{\mu_d} \ = \ 0{,}50 \times \mu_d(0{,}20 \ \text{m/s}) + 0{,}35 \times \mu_d(0{,}15 \ \text{m/s}) + 0{,}15 \times \mu_d(0{,}07 \ \text{m/s}) \quad \text{(X)}$$

Der gewichtete mittlere dynamische Reibungskoeffizient wird, da er ein Maß für die gefühlte Glattheit ist, auch als haptischer Glattheitskoeffizient HGK bezeichnet. Entsprechend gilt:

$$\text{HGK} \ = \ 0{,}50 \times \mu_d(0{,}20 \ \text{m/s}) + 0{,}35 \times \mu_d(0{,}15 \ \text{m/s}) + 0{,}15 \times \mu_d(0{,}07 \ \text{m/s}) \quad \text{(XI)}$$

Je kleiner der haptische Glattheitskoeffizient HGK, desto größer die gefühlte Glattheit der Oberfläche des Brillenglases. Messtechnisch entspricht der haptische Glattheitskoeffizient also dem gewichteten mittleren dynamischen Reibungskoeffizienten, welcher unter speziellen Parametern, etwa in Bezug auf das verwendete Mikrofasertuch und die Messgeometrie, wie vorstehend erläutert, ermittelt wird. Überraschenderweise reicht die Bestimmung des dynamischen Reibungskoeffizienten bei drei tangentialen Geschwindigkeiten, nämlich bei 0,20 m/s, 0,15 m/s und 0,07 m/s, bereits aus, um die gefühlte Glattheit messtechnisch ausreichend exakt abzubilden.

Mit dem haptischen Glattheitskoeffizienten HGK lässt sich die gefühlte Glattheit messtechnisch ausreichend exakt abbilden. Die sensorisch mit dem Finger ertastete Glattheit lässt sich messtechnisch noch besser abbilden, wenn man die Beschleunigungsphase in der Nähe des Umkehrpunkts miteinbezieht. Zu diesem Zweck wird zusätzlich ein dynamischer Reibungskoeffizient, welcher bei einer vergleichsweise geringen Geschwindigkeit bestimmt wird, berücksichtigt. Eine sehr gute Vergleichbarkeit zwischen empirischen Versuchen zur Glattheit und der Beschreibung der Glattheit mittels Reibungskurven erzielt man dadurch, wenn man bei einer tangentialen Geschwindigkeit von 0,01 m/s, welche nahe am Stillstand liegt, den dynamischen Reibungskoeffizienten bestimmt und unter Multiplikation mit einem Gewichtungsfaktor von 3 zum haptischen Glattheitskoeffizienten HGK addiert. Der so erhaltene haptische Glattheitskoeffizient R_HGK lautet dann wie folgt:

$$\text{R\_HGK} \ = \ \text{HGK} + 3 \times \mu_d(0{,}01 \ \text{m/s}) \quad \text{(XII)}$$

Das erfindungsgemäße Messverfahren ist grundsätzlich nicht auf die Bestimmung der Glattheit eines Brillenglases beschränkt. Es kann grundsätzlich auf jede Art von beschichteter oder unbeschichteter Oberfläche angewendet werden. Mit Hilfe der beiden haptischen Glattheitskoeffizienten HGK und R_HGK lassen sich beispielsweise verschiedene Oberflächenbeschichtungen unterscheiden und in ihrer Qualität objektiv bewerten. Auf diese Weise können Grenzwerte für unterschiedliche Qualitätsstufen definiert werden.

Figurenbeschreibung

Fig. 1 zeigt eine graphische Darstellung des Zusammenhangs zwischen Geschwindigkeit und Weg bei der Wischbewegung über ein Brillenglas für einen 1/4-Putzhub. Im Vergleich zur Kurve auf der linken Seite sind bei der Kurve auf der rechten Seite zusätzlich drei Balken eingefügt, deren Fläche jeweils der Fläche unter dem dazugehörigen Kurvenabschnitt entspricht.

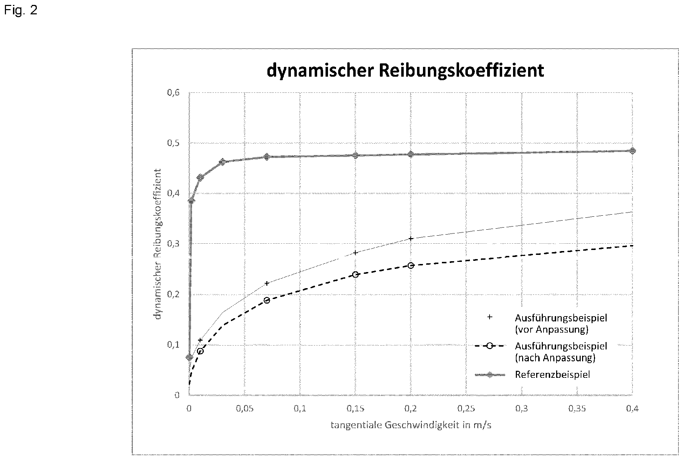

Fig. 2 zeigt den dynamischen Reibungskoeffizienten in Abhängigkeit der Wischgeschwindigkeit für die beschichteten Kunststoffbrillengläser aus dem Ausführungsbeispiel sowie aus dem Referenzbeispiel. Die Kurven sind durch Bestimmung der dynamischen Reibungskoeffizienten bei tangentialen Geschwindigkeiten von 0,0002 m/s, 0,002 m/s, 0,01 m/s, 0,03 m/s, 0,07 m/s, 0,15 m/s, 0,20 m/s und 0,40 m/s sowie anschließende Interpolation anhand der bei diesen Geschwindigkeiten bestimmten dynamischen Reibungskoeffizienten erhalten worden. Die für die Berechnung relevanten Stellen (0,01 m/s, 0,07 m/s, 0,15 m/s und 0,20 m/s) sind durch Markierungen gekennzeichnet.

**Beispiele**

Das nachstehende Ausführungsbeispiel dient der weiteren Erläuterung der vorliegenden Erfindung, ohne jedoch hierauf beschränkt zu sein.

Als Substrat für die Beschichtung diente ein rohrundes Kunststoffbrillenglas mit den nachstehenden Eigenschaften:

- Durchmesser:                          60 mm
- Brechungsindex:                       1,60
- Brechkraft (sphärische Wirkung):      -2,25 dpt

Mit Hilfe eines Tauchverfahrens wurde zunächst eine Hartschicht auf das Substrat aufgebracht. Auf dieses wurde wiederum mit Hilfe eines ionengestützten physikalischen Gasphasenabscheidungsverfahrens eine Interferenz-/Entspiegelungsschicht aufgebracht. Nach Aufbringen der letzten Schicht der Interferenz-/Entspiegelungsschicht wurde die Oberfläche einer Plasmabehandlung unterzogen, bevor hierauf die funktionelle Beschichtung aufgedampft wurde. Zu diesem Zweck wurde eine Pille des Typs "Surfclear 100M" in einer Vakuumbeschichtungsanlage per Widerstandsverdampfer mit einem Schiffchenstrom von 5,4 A erhitzt. Dabei bildete sich eine funktionelle Beschichtung mit einer Dicke von 9 nm auf der Interferenz-/Entspiegelungsschicht aus. Die maximale Aufdampfrate betrug 0,44 nm/s bei einer Beschichtungszeit von 50 Sekunden. Nach dem Aufbringen der funktionellen Beschichtung wurde der Beschichtungsvorgang beendet und die Vakuumbeschichtungsanlage wurde belüftet.

Das so erhaltene Brillenglas wurde nach der Beschichtung keiner weiteren Behandlung unterworfen, insbesondere keiner reibenden Aktion ausgesetzt, die über eine übliche Reinigung durch Wischen hinausgeht.

Anschließend wurde das Brillenglas in Übereinstimmung mit dem erfindungsgemäßen Messverfahren hinsichtlich seiner Glattheit vermessen. Zu diesem Zweck wurde das Brillenglas zunächst mittels einer Halterung in einem Rheometer des Typs "Haake Mars iQ Air" mittig auf der unteren Auflage der Messvorrichtung fixiert, sodass die funktionelle Beschichtung, welche auf der konvexen Seite des Substrats aufgebracht war, in Richtung des Rotors der Messvorrichtung zeigte. Die Mitte des Brillenglases kam dabei genau unter der Mitte des Rotors zu liegen. Auf die Oberfläche des Brillenglases wurde sodann ein Mikrofasertuch des Typs "Savina MX", hergestellt von "kbSeiren", Osaka, Japan, mit Abmessungen von 45 mm × 45 mm platziert. Der Rotor der Messvorrichtung war so ausgelegt, dass sich an dessen unterem Ende eine kreisförmige Platte befand, auf der wiederum mittig ein Silikonring mit einem Innenradius von 17,5 mm, einem Außenradius von 20,5 mm und einer Höhe von 3 mm angebracht war. Der Silikonring besaß eine Shore-Härte A von 40.

Zur Messung des dynamischen Reibungskoeffizienten wurde der Rotor auf die konvexe Seite des Brillenglases abgesenkt. Mit Hilfe des Silikonrings des Rotors wurde das Mikrofasertuch mit einer Andruckkraft von 3 N senkrecht auf die Oberfläche des Brillenglases gedrückt. Durch Rotieren des Rotors wurde das Mikrofasertuch relativ zur Oberfläche des Brillenglases für eine bestimmte Zeitdauer, die vier Umläufen des Mikrofasertuchs auf der Oberfläche des Brillenglases entsprach, gleichmäßig bewegt, wobei dies mit einer Geschwindigkeit von 0,01 m/s tangential zum Außenradius des Silikonrings erfolgte. Durch die Messvorrichtung wurde zeitgleich das Drehmoment, welches zur Bewegung des Mikrofasertuchs relativ zur Oberfläche des Brillenglases erforderlich war, ermittelt. Hieraus ließ sich schließlich der dynamische Reibungskoeffizient für die tangentiale Geschwindigkeit von 0,01 m/s bestimmen. Die Bestimmung des dynamischen Reibungskoeffizienten für die tangentialen Geschwindigkeiten von 0,07 m/s, 0,15 m/s und 0,20 m/s erfolgte analog hierzu. Dabei wurde die Anzahl der Umläufe an die jeweilige Geschwindigkeit unter Berücksichtigung einer Beschleunigungsphase zum Erreichen einer gleichmäßigen Geschwindigkeit angepasst und betrug zwischen vier und acht Umläufen.

Aus den so bestimmten dynamischen Reibungskoeffizienten ergaben sich ein HGK von 0,287 gemäß Formel (XI) und ein R_HGK von 0,614 gemäß Formel (XII).

Um eine höhere Qualitätsstufe in dem darauffolgenden Verfahrenszyklus zu erreichen, insbesondere im Hinblick auf den HGK von 0,287, wurde eine Anpassung der Beschichtungsparameter vorgenommen. Im vorliegenden Fall wurden die Beschichtungsparameter dahingehend angepasst, dass als Abschaltbedingung eine zu erreichende physikalische Schichtdicke der funktionellen Beschichtung von 13 nm mit einer maximalen Aufdampfrate von 0,43 nm/s bei einer Beschichtungszeit von 68 Sekunden eingestellt wurde.

Anschließend wurde unter den angepassten Beschichtungsparametern ein identisches Substrat in der Vakuumbeschichtungsanlage mit einer funktionellen Beschichtung versehen. Die dynamischen Reibungskoeffizienten wurden wie zuvor bestimmt.

Aus den so bestimmten dynamischen Reibungskoeffizienten ergaben sich ein HGK von 0,24 gemäß Formel (XI) und ein R_HGK von 0,50 gemäß Formel (XII).

Durch die vorgenommene Anpassung der Beschichtungsparameter konnten die haptischen Glattheitskoeffizienten HGK und R_HGK verringert werden. Entsprechend wies das aus diesem Verfahrenszyklus erhaltene Brillenglas eine verbesserte Glattheit auf.

Als Referenzbeispiel wurde ein handelsübliches Brillenglas, welches bezüglich seines Substrats baugleich zu dem Kunststoffbrillenglas aus dem Ausführungsbeispiel war, jedoch nicht mit einer entsprechenden funktionellen Beschichtung versehen war, verwendet.

Auch hier erfolgte die Messung der dynamischen Reibungskoeffizienten bei tangentialen Geschwindigkeiten von 0,01 m/s, 0,07 m/s, 0,15 m/s und 0,20 m/s, wie im Zusammenhang mit dem Ausführungsbeispiel beschrieben.

Aus den so bestimmten dynamischen Reibungskoeffizienten ergaben sich ein HGK von 0,473 gemäß Formel (XI) und ein R_HGK von 1,77 gemäß Formel (XII).

Das Brillenglas aus dem Referenzbeispiel genügte damit nicht den Qualitätsanforderungen in Bezug auf die Glattheit.

Wie sich Fig. 2 entnehmen lässt, ist der geschwindigkeitsabhängige dynamische Reibungskoeffizient im Falle der beschichteten Kunststoffbrillengläser aus dem Ausführungsbeispiel vergleichsweise niedrig. Mit zunehmender tangentialer Geschwindigkeit lässt sich nur ein geringfügiger Anstieg des dynamischen Reibungskoeffizienten beobachten. Somit ist ein besonders leichtgängiges Wischen mit geringem Kraftaufwand möglich. Demgegenüber ist bei dem Brillenglas aus dem Referenzbeispiel der dynamische Reibungskoeffizient deutlich erhöht.

**Patentansprüche**

1. Messverfahren zur Bestimmung der Glattheit eines Brillenglases mit Hilfe eines Rheometers unter Bestimmung dynamischer Reibungskoeffizienten gegenüber einem Mikrofasertuch, welches eine Kreisbahn um die Mitte des Brillenglases beschreibt, wobei die Bestimmung dynamischer Reibungskoeffizienten bei Geschwindigkeiten im Bereich von 0,005 m/s bis 0,4 m/s tangential zur beschriebenen Kreisbahn sowie tangential zur Oberfläche des Brillenglases erfolgt,
   **dadurch gekennzeichnet, dass** die Glattheit des Brillenglases durch einen haptischen Glattheitskoeffizienten HGK ausgedrückt wird und das Verfahren umfasst:

   Wischen mit einem Mikrofasertuch in einer rotierenden Bewegung um die Mitte des Brillenglases, wobei das Wischen mit Hilfe eines Rotors, der auf die konvexe Seite des Brillenglases abgesenkt wird, erfolgt, der Andruck des Mikrofasertuchs auf die zu messende Oberfläche des Brillenglases durch einen elastischen Stempel mit ringförmiger Auflagefläche geschieht, und sich das Mikrofasertuch im Bereich der ringförmigen Auflagefläche relativ zur Oberfläche des Brillenglases mit einer Geschwindigkeit im Bereich von 0,005 m/s bis 0,4 m/s tangential zum Außenradius der ringförmigen Auflagefläche bewegt,
   Ermitteln des Drehmoments während der rotierenden Bewegung des Mikrofasertuchs mit Hilfe eines Rheometers,
   Bestimmen des dynamischen Reibungskoeffizienten anhand des zuvor ermittelten Drehmoments,
   Wiederholen der vorstehenden Schritte bei einer anderen Geschwindigkeit im Bereich von 0,005 m/s bis 0,4 m/s tangential zum Außenradius der ringförmigen Auflagefläche, und
   Berechnen des haptischen Glattheitskoeffizienten HGK aus mindestens zwei mit verschiedenen tangentialen Geschwindigkeiten bestimmten dynamischen Reibungskoeffizienten.

2. Messverfahren nach Anspruch 1, wobei dynamische Reibungskoeffizienten, welche bei tangentialen Geschwindigkeiten von 0,20 m/s, 0,15 m/s und 0,07 m/s bestimmt werden, Eingang in die Berechnung des haptischen Glattheitskoeffizienten HGK finden.

3. Messverfahren nach Anspruch 2, wobei der haptische Glattheitskoeffizient HGK anhand der nachstehenden Formel (XI) berechnet wird:

$$HGK = 0{,}50 \times \mu_d(0{,}20 \text{ m/s}) + 0{,}35 \times \mu_d(0{,}15 \text{ m/s}) + 0{,}15 \times \mu_d(0{,}07 \text{ m/s}) \quad (XI)$$

worin $\mu_d(0{,}20 \text{ m/s})$ der bei einer tangentialen Geschwindigkeit von 0,20 m/s bestimmte dynamische Reibungskoeffizient ist, $\mu_d(0{,}15 \text{ m/s})$ der bei einer tangentialen Geschwindigkeit von 0,15 m/s bestimmte dynamische Reibungskoeffizient ist und $\mu_d(0{,}07 \text{ m/s})$ der bei einer tangentialen Geschwindigkeit von 0,07 m/s bestimmte dynamische Reibungskoeffizient ist.

4. Messverfahren nach Anspruch 3, wobei zusätzlich der dynamische Reibungskoeffizient bei einer tangentialen Geschwindigkeit von 0,01 m/s bestimmt wird und dieser Eingang in die Berechnung eines haptischen Glattheitskoeffizienten R_HGK anhand der nachstehenden Formel (XII) findet:

$$R\_HGK = HGK + 3 \times \mu_d(0{,}01 \text{ m/s}) \quad (XII)$$

worin $\mu_d(0{,}01 \text{ m/s})$ der bei einer tangentialen Geschwindigkeit von 0,01 m/s bestimmte dynamische Reibungskoeffizient ist.

**Claims**

1. Measuring method for determining the smoothness of a spectacle lens using a rheometer to determine dynamic friction coefficients against a microfiber cloth, which describes a circular path around the center of the spectacle lens, wherein the determination of dynamic friction coefficients is carried out at speeds in the range from 0.005 m/s to 0.4 m/s tangential to the described circular path and tangential to the surface of the eyeglass lens, **characterized in that** the smoothness of the eyeglass lens is expressed by a haptic smoothness coefficient HGK and the method comprises:

    wiping with a microfiber cloth in a rotating motion around the center of the eyeglass lens, wherein the wiping is performed with the aid of a rotor that is lowered onto the convex side of the eyeglass lens, the pressure of the microfiber cloth onto the surface of the eyeglass lens to be measured is exerted by an elastic stamp with a ring-shaped contact surface, and the microfiber cloth moves in the area of the annular contact surface relative to the surface of the eyeglass lens at a speed in the range of 0.005 m/s to 0.4 m/s tangentially to the outer radius of the annular contact surface ,
    Determining the torque during the rotating movement of the microfiber cloth using a rheometer,
    Determining the dynamic friction coefficient based on the previously determined torque,
    Repeating the above steps at a different speed in the range from 0.005 m/s to 0.4 m/s tangential to the outer radius of the annular contact surface , and
    Calculating the haptic smoothness coefficient HGK from at least two dynamic friction coefficients determined at different tangential speeds.

2. Measuring method according to claim 1, wherein dynamic friction coefficients determined at tangential velocities of 0.20 m/s, 0.15 m/s, and 0.07 m/s are included in the calculation of the haptic smoothness coefficient HGK.

3. Measuring method according to claim 2, wherein the haptic smoothness coefficient HGK is calculated using the following formula (XI):

$$HGK = 0{,}50 \times \mu_d(0{,}20 \text{ m/s}) + 0{,}35 \times \mu_d(0{,}15 \text{ m/s}) + 0{,}15 \times \mu_d(0{,}07 \text{ m/s}) \quad (XI)$$

wherein $\mu_d(0{,}20 \text{ m/s})$ is the dynamic friction coefficient determined at a tangential velocity of 0.20 m/s, $\mu_d(0{,}15 \text{ m/s})$ is the dynamic friction coefficient determined at a tangential velocity of 0.15 m/s, and $\mu_d(0{,}07 \text{ m/s})$ is the dynamic friction coefficient determined at a tangential velocity of 0.07 m/s.

4. Measuring method according to claim 3, wherein the dynamic friction coefficient at a tangential velocity of 0.01 m/s is additionally determined and this is used in the calculation of a haptic smoothness coefficient R_HGK using the following formula (XII):

$$R\_HGK = HGK + 3 \times \mu_d(0{,}01 \text{ m/s}) \quad (XII)$$

wherein $\mu_d(0.01$ m/s) is the dynamic friction coefficient determined at a tangential velocity of 0.01 m/s.

**Revendications**

1.  Procédé de mesure pour déterminer le caractère lisse d'un verre de lunettes à l'aide d'un rhéomètre en déterminant des coefficients de frottement dynamiques par rapport à un tissu en microfibres qui décrit une trajectoire circulaire autour du centre du verre de lunettes, la détermination des coefficients de frottement dynamiques s'effectuant à des vitesses dans la plage de 0,005 m/s à 0,4 m/s tangentiellement à la trajectoire circulaire décrite ainsi que tangentiellement à la surface du verre de lunettes,
    **caractérisé en ce que** le lissé du verre de lunettes est exprimé par un coefficient de lissé haptique HGK et le procédé comprend :

    l'essuyage avec un chiffon en microfibres dans un mouvement de rotation autour du centre du verre de lunettes, l'essuyage étant effectué à l'aide d'un rotor qui est abaissé sur la face convexe du verre de lunettes, la pression du chiffon en microfibres sur la surface à mesurer du verre de lunettes étant effectuée par un poinçon élastique avec une surface d'appui annulaire, et le tissu en microfibres se déplace dans la zone de la surface d'appui annulaire par rapport à la surface du verre de lunettes à une vitesse de l'ordre de 0,005 m/s à 0,4 m/s tangentiellement au rayon extérieur de la surface d'appui annulaire ,
    Déterminer le couple de rotation pendant le mouvement rotatif du tissu en microfibres à l'aide d'un rhéomètre,
    Détermination du coefficient de frottement dynamique à l'aide du couple de rotation déterminé précédemment,
    Répétition des étapes précédentes à une autre vitesse comprise entre 0,005 m/s et 0,4 m/s tangentiellement au rayon extérieur de la surface d'appui annulaire , et
    calculer le coefficient de lissage haptique HGK à partir d'au moins deux coefficients de frottement dynamique déterminés à des vitesses tangentielles différentes.

2.  Procédé de mesure selon la revendication 1, dans lequel les coefficients de frottement dynamiques, qui sont déterminés à des vitesses tangentielles de 0,20 m/s, 0,15 m/s et 0,07 m/s, sont pris en compte dans le calcul du coefficient de lissé haptique HGK.

3.  Procédé de mesure selon la revendication 2, dans lequel le coefficient de lissé haptique HGK est calculé à l'aide de la formule (XI) suivante :

$$HGK = 0{,}50 \times \mu_d(0{,}20 \text{ m/s}) + 0{,}35 \times \mu_d(0{,}15 \text{ m/s}) + 0{,}15 \times \mu_d(0{,}07 \text{ m/s}) \quad (XI)$$

où $\mu_d(0{,}20$ m/s) est le coefficient de frottement dynamique déterminé à une vitesse tangentielle de 0,20 m/s, $\mu_d(0{,}15$ m/s) est le coefficient de frottement dynamique déterminé à une vitesse tangentielle de 0,15 m/s et $\mu_d(0{,}07$ m/s) est le coefficient de frottement dynamique déterminé à une vitesse tangentielle de 0,07 m/s.

4.  Procédé de mesure selon la revendication 3, dans lequel on détermine en outre le coefficient de frottement dynamique à une vitesse tangentielle de 0,01 m/s et on le prend en compte dans le calcul d'un coefficient de lissé haptique R_HGK à l'aide de la formule (XII) suivante :

$$R\_HGK = HGK + 3 \times \mu_d(0{,}01 \text{ m/s}) \quad (XII)$$

où $\mu_d(0{,}01$ m/s) est le coefficient de frottement dynamique déterminé à une vitesse tangentielle de 0,01 m/s.

Fig. 1

Fig. 2

**dynamischer Reibungskoeffizient**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2078765 A1

- US 2005179862 A1